# EUROPÄISCHE PATENTSCHRIFT

(11) **EP 4 471 435 B1**
(45) Veröffentlichungstag und Bekanntmachung des Hinweises auf die Patenterteilung: **28.10.2026**
(21) Anmeldenummer: 24199871.5
(22) Anmeldetag: 17.01.2019
(51) Int. Cl.: G01R 1/07, G01R 1/073, G01R 31/28, G01R 1/067

(54) **PRÜFNADEL, PRÜFSONDE UND FINGERTESTER ZUM TESTEN VON LEITERPLATTEN**
TEST NEEDLE, TEST PROBE AND FINGER TESTER FOR TESTING PRINTED CIRCUIT BOARDS
AIGUILLE DE TEST, SONDE DE TEST ET TESTEUR À DOIGT POUR TESTER LES CIRCUITS IMPRIMÉS

(30) Priorität: 18.01.2018 DE 102018101031; 16.10.2018 DE 102018125666
(43) Veröffentlichungstag der Anmeldung: 04.12.2024
(62) Dokumentnummer(n) der früheren Anmeldung(en) nach Art. 76 EPÜ: 19701082.0 / 3 740 767
(73) Patentinhaber: atg Mycronic GmbH, 97877 Wertheim (DE)
(72) Erfinder: WEISS, Stefan, 97877 Wertheim (DE); YUSCHUK, Oleh, 97877 Wertheim (DE); WEINDEL, Christian, 75248 Ölbronn-Dürm (DE)
(74) Vertreter: HGF

(56) Entgegenhaltungen:
- EP-A2- 0 551 564
- JP-A- 2007 278 820
- NEVILLE K S LEE ET AL: "Design of precision measurement system for metallic hole", THE INTERNATIONAL JOURNAL OF ADVANCED MANUFACTURING TECHNOLOGY, SPRINGER, BERLIN, DE, vol. 44, no. 5-6, 2 December 2008 (2008-12-02), pages 539 - 547, XP019735913, ISSN: 1433-3015

## Beschreibung

Die vorliegende Erfindung betrifft eine Prüfnadel zum Messen von elektrisch leitenden Schichten in Bohrungen von Leiterplatten, sowie eine Prüfsonde mit einer solchen Prüfnadel und einen Fingertester zum Testen von Leiterplatten mit einer solchen Prüfnadel bzw. mit einer solchen Prüfsonde.

Bei der Herstellung von Leiterplatten werden die Leiterplatten oft mit sogenannten Coupons zunächst produziert. Die Coupons sind Bereiche der Leiterplatte, welche vorbestimmte Leiterbahnen aufweisen, um daran Messungen durchzuführen. Nach Durchführung der Messungen, um zu testen, ob die Leiterplatte ordnungsgemäß hergestellt worden ist, werden die Coupons von dem Rest der Leiterplatte getrennt. Die übrige Leiterplatte bildet einen oder mehrere sogenannter Nutzen, welche mit elektrischen Bauelementen bestückt und in elektrischen Produkten eingesetzt werden.

An den Coupons können unterschiedliche elektrische Eigenschaften gemessen werden. Die Coupons weisen spezielle Leiterbahnen auf, an welchen einfach festgestellt werden kann, ob das Produktionsverfahren z.B. den Anforderungen zum Herstellen hochfrequenzgeeigneter Leiterbahnen genügt. Weiterhin können an den Leiterbahnen des Coupons Belastungstests durchgeführt werden, welche einzelne Leiterbahnen an den Coupons auch zerstören können. Da die Leiterbahnen der Coupons in späteren Produkten nicht verwendet werden, können sie speziell für bestimmte Testvorgänge optimiert sein.

Es lassen sich jedoch nicht alle Messungen an den Coupons auf die Leiterbahnen eines Nutzens übertragen. Einerseits haben die Leiterbahnen auf dem Nutzen oftmals eine andere Geometrie als auf dem Coupon, so dass die Übertragung der Messergebnisse im Coupon nicht immer für die Leiterbahnen des Nutzens gilt.

Es gibt seit langem auch Messsonden, um an Leiterbahnen des Nutzens Hochfrequenzsignale anzulegen, um deren Hochfrequenzeigenschaften zu testen. Eine solche Hochfrequenzmessung kann nur dann zuverlässig durchgeführt werden, wenn das Kontaktieren der Leiterbahn elektrisch angepasst erfolgt. Entstehen Reflexionen, dann ist es schwierig, die eigentliche Störstelle zu erkennen. Weiterhin benötigt eine Hochfrequenzmessung immer einen Massebezugspunkt nahe am Kontaktpunkt. Der Aufbau eines entsprechenden Messkopfes ist dementsprechend aufwändig.

Zum Vermessen der elektrisch leitenden Schicht in zurückgebohrten Bohrungen ist aus der US 9,459,285 B2 ein entsprechender Tastkopf mit leitfähigem Elastomer bekannt, mit welchem die leitfähigen Schichten mechanisch abgetastet und elektrisch vermessen werden können.

Weiterhin ist es aus der US 8,431,834 B2 bekannt, eine Leiterplatte mit einer zusätzlichen Leiterbahn zu versehen, so dass durch eine Impedanzmessung zwischen dieser zusätzlichen Leiterbahn und der eigentlichen Leiterbahn überprüft werden kann, ob die Rückbohrung tief genug oder gar schon zu tief erfolgt ist. Das Vorsehen einer solchen zusätzlichen Leiterbahn ist sehr aufwändig und erhöht die Kosten einer mehrlagigen Leiterplatte erheblich.

Aus der US 2015/047892 A1 geht ein Verfahren hervor, bei dem ein Bohrer gleichzeitig als Sonde verwendet wird, um beim Zurückbohren den elektrischen Kontakt zur Leiterbahn zu messen und so den Bohrer dementsprechend zu steuern.

Aus den Patenten US 9,341,670 B2, US 9,488,690 B2 und US 9,739,825 B2 sind Verfahren und Vorrichtungen bekannt, mit welchen sogenannte "Stubs" in Bohrungen einer Leiterplatte vermessen werden können. Derartige Stubs sind Reste oder Stummel einer elektrisch leitenden Schicht in einer Bohrung der Leiterplatte, welche in der Regel mit einer Leiterbahn in elektrischer Verbindung stehen. Um solche Stubs zu entfernen, werden Bohrungen einer Leiterplatte oftmals ein zweites Mal gebohrt, was als Zurückbohren (Englisch: back drilling) bezeichnet wird. Durch dieses Zurückbohren können derartige Stubs, welche beim Beschichten der einzelnen Lagen mit der elektrisch leitenden Schicht, welche in der Regel eine Kupferschicht ist, aus Versehen erzeugt worden sind, entfernt werden. Bei diesem Zurückbohren können jedoch auch gewünschte elektrische Verbindungen der Leiterbahn unterbrochen werden. Diese Vorrichtung weist eine kapazitive Sonde auf, welche in eine zurückgebohrte Bohrung einer Leiterplatte eingebracht wird. Die Kapazität der kapazitiven Sonde wird gemessen. Weiterhin vorhandenes elektrisch leitendes Material in der zurückgebohrten Bohrung wird anhand der Kapazität erkannt. Hierdurch können Fehler beim Zurückbohren detektiert werden.

Der Artikel "Design of precision measurement system for metallic hole" erschienen im International Journal of Advanced Manufacturing Technology, Springer, Berlin, DE, Bd. 44, Nr. 5-6, 2. Dezember 2008 (2008-12-02), Seiten 539-547, ISSN: 1433-3015 befasst sich mit einem Präzisionsmesssystem für metallische Löcher, das auf einer Kapazitätsmessung beruht. Die kapazitive Messung umfasst eine Sonde, die als stangenförmige Sonde oder als scheibenförmige Sonde ausgebildet ist. Die Sonde wird in das passende Loch eingeführt und bildet mit dem das Loch umgebenden Metall eine kapazitive Kopplung aus, die gemessen wird, um Informationen über das Loch zu gewinnen.

Der vorliegenden Erfindung liegt die Aufgabe zugrunde, eine Prüfnadel zum Messen von elektrisch leitenden Schichten in Bohrungen von Leiterplatten sowie eine entsprechende Prüfsonde als auch einen Fingertester zu schaffen, mit welchen einfach, zuverlässig und sehr präzise eine zurückgebohrte Bohrung einer Leiterplatte gemäß dem in der US 9,341,670 B2 beschriebenen Verfahren vermessen werden kann.

Die Aufgabe wird durch die Gegenstände der unabhängigen Ansprüche gelöst. Vorteilhafte Ausgestaltungen der Erfindung sind in den jeweiligen Unteransprüchen angegeben.

Eine erfindungsgemäße Prüfnadel zum Messen von elektrisch leitenden Schichten in Bohrungen von Leiterplatten umfasst einen elektrischen Leiter, welcher von einer Abschirmung umgeben ist, wobei die Prüfnadel ein Anschlussende, an welchem sie mit einer kapazitiven Messeinrichtung elektrisch verbindbar ist, und ein Messende aufweist, das bei einer Messung in eine Bohrung einführbar ist.

Diese Prüfnadel weist am Messende ein mit dem elektrischen Leiter verbundenen kapazitiven Messkörper auf, der außerhalb der Abschirmung angeordnet ist, welcher mit einer elektrisch leitenden Schicht in der Bohrung eine kapazitive Kopplung ausbilden kann. Der Messkörper ist in Form eines Hohlzylinders ausgebildet. Am Messende der Prüfnadel ist eine elektrisch leitende Messspitze ausgebildet.

Dadurch, dass der elektrische Leiter der Prüfnadel abgeschirmt ist und lediglich der kapazitive Messkörper mit einem anderen elektrisch leitenden Körper eine kapazitive Kopplung ausbilden kann, kann mit der Prüfnadel sehr präzise der Ort des kapazitiven Messkörpers anhand der gemessenen Kapazität in Bezug zu einer elektrisch leitenden Schicht erfasst werden.

Der Messkörper ist vorzugsweise mit einer elektrischen Isolationsschicht umgeben, so dass kein elektrischer Kontakt zwischen dem Messkörper und einem weiteren elektrisch leitenden Körper stattfinden kann.

Der Messkörper besitzt vorzugsweise einen maximalen Durchmesser von 1,5 mm, insbesondere einen maximalen Durchmesser von 1 mm, und vorzugsweise einen maximalen Durchmesser von 0,75 mm.

Der Messkörper weist vorzugsweise in Axialrichtung der Prüfnadel eine maximale Länge von 0,5 mm, vorzugsweise eine maximale Länge von 0,25 mm und insbesondere eine maximale Länge von 0,15 mm auf.

Je kleiner der Messkörper ausgebildet ist, desto präziser ist die örtliche Auflösung, welche mit der Prüfnadel erfassbar ist.

Andererseits gilt, je größer die Fläche ist, über die sich der Messkörper erstreckt, desto größer ist die kapazitive Kopplung mit einer elektrisch leitenden Schicht in der Bohrung und desto stärker ist das gemessene Signal. Zur Detektion einer elektrisch leitenden Schicht muss daher ein Kompromiss zwischen der Ortsauflösung und der kapazitiven Kopplung eingegangen werden.

Die Prüfnadel kann ein elektrisch leitendes Röhrchen aufweisen, welches die Abschirmung bildet, in welchem ein Kabel, das den elektrischen Leiter und eine elektrische Isolationsschicht umfasst, geführt ist. Das Kabel kann am Anschlussende aus dem Röhrchen ein Stück vorstehen, um an die kapazitive Messeinrichtung angeschlossen zu werden.

Eine Prüfsonde zum Messen von elektrisch leitenden Schichten in Bohrungen von Leiterplatten kann mit einer oben erläuterten Prüfnadel versehen sein und weist einen Berührungssensor auf, mit welchem feststellbar ist, ob die Prüfnadel einen anderen Körper berührt.

Mit dem Berührungssensor kann die Tiefe einer Sacklochbohrung gemessen werden, indem die Prüfsonde einmal die Oberfläche der zu testenden Leiterplatte und ein anderes Mal einen Boden der Sacklochbohrung berührt und die jeweilige Berührung detektiert und hierbei die Position der Prüfsonde erfasst. Die Differenz der beiden Positionen ergibt die Tiefe der Sacklochbohrung.

Die eigentliche kapazitive Messung sollte möglichst berührungsfrei erfolgen, weshalb mit dem Berührungssensor zudem versucht werden kann, festzustellen, ob eine Berührung mit einem anderen Körper vorliegt, um dann gegebenenfalls die Prüfnadel so zu bewegen, dass sie den Körper nicht mehr berührt.

Der Berührungssensor kann eine federelastische Halterung zum Halten der Prüfnadel und einen Sensor zum Detektieren einer Auslenkung der federelastischen Halterung aufweisen.

Der Sensor zum Detektieren einer Auslenkung der federelastischen Halterung kann ein optischer Sensor sein. Dieser optische Sensor kann auf unterschiedliche Art und Weise ausgebildet sein. Eine Lichtquelle kann beispielsweise an der federelastischen Halterung direkt oder mittelbar über einen Lichtleiter angeordnet sein, wobei der Lichtaustritt mittels eines optischen Sensors detektiert wird. Beim Auslenken der federelastischen Halterung wird der Lichtkegel vom optischen Sensor wegbewegt, was durch eine unterschiedliche Helligkeit detektierbar ist. Gleichermaßen ist es möglich, eine Lichtschranke vorzusehen.

An der Prüfsonde kann ein Anschlag ausgebildet sein, an welchem die Prüfnadel und/oder die federelastische Halterung im nicht-ausgelenkten Zustand anliegt. Hierdurch ist die Position der Prüfnadel im nicht ausgelenkten Zustand eindeutig bezüglich der Prüfsonde definiert. Ist die Position der Prüfsonde bekannt, dann kann hieraus auch die Position der Prüfnadel und damit die Position des Messkörpers abgeleitet werden.

Ein Fingertester zum Testen von Leiterplatten, insbesondere zum Testen von unbestückten Leiterplatten, weist vorzugsweise einen Testfinger auf, welcher frei in einem vorbestimmten Prüfbereich bewegbar ist, um in die Nähe einer vorbestimmten Kontaktstelle der Leiterplatte bewegbar zu sein. Der Testfinger kann mit einer oben erläuterten Prüfnadel oder mit einer oben erläuterten Prüfsonde versehen sein.

Der Fingertester kann mehrere Testfinger aufweisen, wobei einer oder mehrere der weiteren Testfinger mit einer Prüfnadel zum elektrischen Kontaktieren von vorbestimmten Kontaktstellen der Leiterplatte ausgebildet sind.

Gemäß einem weiteren Aspekt betrifft die Erfindung ein Verfahren zum Messen von elektrisch leitenden Schichten in Bohrungen von Leiterplatten. Hierzu wird eine oben erläuterte Prüfnadel oder eine oben erläuterte Prüfsonde oder der oben erläuterte Fingertester verwendet. Die Prüfnadel wird mit dem kapazitiven Messkörper in eine Bohrung eingeführt. Der Ort des kapazitiven Messkörpers wird hierbei erfasst und gleichzeitig wird die elektrische Kapazität des kapazitiven Messkörpers zu seiner Umgebung gemessen. Anhand der gemessenen Kapazität wird bestimmt, ob in der Nähe des erfassten Ortes sich ein elektrischer Leiter befindet. Durch das gleichzeitige Erfassen des Ortes des kapazitiven Messkörpers und der damit gemessenen Kapazität kann somit festgestellt werden, wo sich ein elektrischer Leiter befindet. Dieser kapazitive Messkörper kann auch in kleine Bohrungen eingeführt werden, so dass an der Innenfläche ausgebildete elektrisch leitende Schichten zuverlässig detektierbar sind.

Neben der eigentlichen Messung der Kapazität kann auch die Tiefe einer zu vermessenden Sacklochbohrung mittels des oben erläuterten Berührungssensors bestimmt werden. Diese Bestimmung der Tiefe kann vor, während oder nach der kapazitiven Messung ausgeführt werden.

Zum Messen der Kapazität wird ein elektrisches Signal mit einer Frequenz von zumindest 1 kHz angelegt. Es können auch höhere Frequenzen von beispielsweise zumindest 2 kHz bzw. zumindest 4 kHz verwendet werden. Das Messsignal kann an den Leiter der Prüfnadel und damit an den kapazitiven Messkörper angelegt werden. An einer Leiterbahn, welche mit einem Abschnitt eines elektrischen Leiters verbunden sein soll, der gemessen werden soll, wird das hierauf induzierte Messsignal abgetastet. Vorzugsweise wird jedoch das Messsignal an eine Leiterbahn angelegt, die mit dem elektrischen Leiter verbunden sein soll, der mit dem kapazitiven Messkörper abgetastet wird. Dann wird auf den kapazitiven Messkörper das Messsignal von diesem elektrischen Leiter induziert und kann von der Messvorrichtung entsprechend erfasst und ausgewertet werden. Dies ist insbesondere zweckmäßig, wenn der elektrische Leiter mit vielen elektrisch leitenden Abschnitten verbunden ist, welche sich in unterschiedlichen Bohrungen befinden. Dann muss ein einziges Mal ein Testfinger an diesem elektrischen Leiter platziert werden und die Prüfsonde kann aufeinanderfolgend in mehreren Bohrungen die darin befindlichen elektrischen Leiter abtasten.

Beim Bestimmen, ob sich ein elektrischer Leiter in der Nähe des Messkörpers befindet, kann ein Vergleich mit einem Kapazitätsprofil einer ordnungsgemäß ausgebildeten Bohrung ausgeführt werden. Eine "ordnungsgemäß ausgeführte Bohrung" ist eine Bohrung, in welcher gewünschte Bereiche der Innenfläche mit einer elektrisch leitenden Schicht versehen sind, die mit dem elektrischen Leiter verbunden sind, an dem das Messsignal angelegt wird und andere Bereiche der Innenfläche der Bohrung nicht mit einer elektrisch leitenden Schicht versehen sind. Die Anordnung der elektrisch leitenden Schicht an der Innenfläche der Bohrung kann somit anhand des Vergleiches festgestellt werden. Stimmt das gemessene Kapazitätsprofil mit dem vorgegebenen Kapazitätsprofil überein, dann ist die Bohrung ordnungsgemäß ausgebildet, d.h. dass nur an den gewünschten Stellen eine elektrisch leitende Schicht vorgesehen ist. Wenn es jedoch Abweichungen gibt, dann bedeutet dies, dass entweder an einer bestimmten Stelle eine elektrisch leitende Schicht fehlt oder an einer bestimmten Stelle eine elektrisch leitende Schicht vorgesehen ist, an der an sich keine elektrisch leitende Schicht angeordnet sein soll.

Die Prüfnadel wird mit diesem Verfahren möglichst immer senkrecht zur Oberfläche der zu testenden Leiterplatte gehalten, da die Bohrungen in der Regel senkrecht zur Oberfläche der Leiterplatte eingebracht sind. Hierdurch ist die Prüfnadel axial zur jeweiligen Bohrung ausgerichtet und die Gefahr einer Kollision mit der Innenfläche einer Bohrung gering.

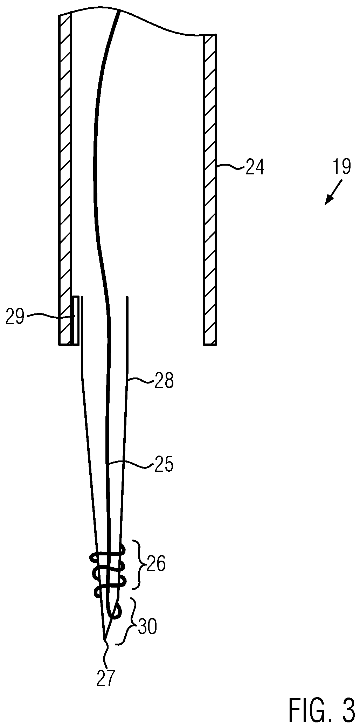

Der unabhängige Anspruch 1 ist dahingehend geändert, dass er auf das Merkmal eines Messkörpers in der Form eines Hohlzylinders beschränkt wurde. Die Beschreibung und Abbildung 3 umfassen jedoch alternative Merkmale eines gewickelten Messkörpers, der nicht in den Schutzbereich fällt. Dies gilt auch für die Ausführungsform mit nicht leitfähiger Spitze.

Nachfolgend wird die Erfindung anhand eines in den Zeichnungen gezeigten Ausführungsbeispiels näher erläutert. Die Zeichnungen zeigen schematisch in:
- Figur 1: einen Fingertester in perspektivischer Ansicht,
- Figur 2a-2c: eine Prüfsonde mit einer erfindungsgemäßen Prüfnadel in perspektivischen Ansichten und in einer Seitenansicht,
- Figur 3: einen Ausschnitt einer Prüfnadel mit Prüfspitze im Querschnitt,
- Figur 4: schematisch eine Messanordnung zum Messen einer elektrisch leitenden Schicht in einer Durchkontaktierung einer Leiterplatte, wobei die Leiterplatte im Querschnitt dargestellt ist und die Masseleiterbahn mit der elektrischen Erde verbunden ist,
- Figur 5: schematisch eine Messanordnung zum Messen einer elektrisch leitenden Schicht in einer Durchkontaktierung einer Leiterplatte, wobei die Leiterplatte im Querschnitt dargestellt ist und die Masseleiterbahn nicht mit der elektrischen Erde verbunden ist, und
- Figur 6: ein Ersatzschaltbild der Messanordnungen zum berührungslosen Messen leitenden Schicht in einer Durchkontaktierung gemäß Figur 4 und 5.

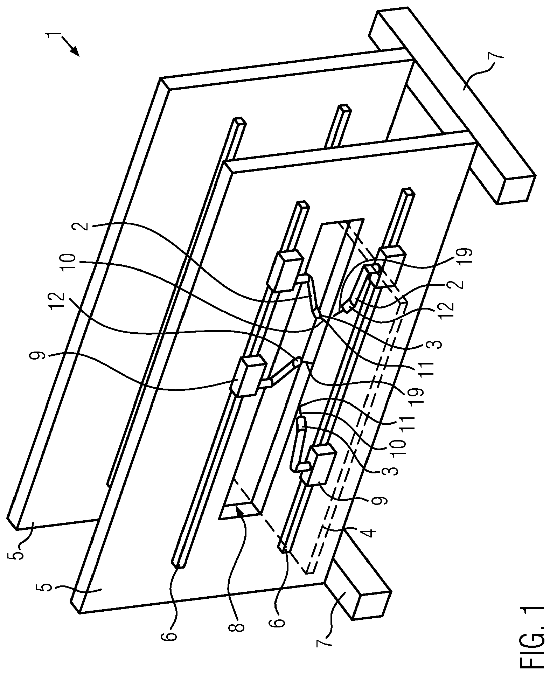

Die Erfindung kann mittels eines Fingertesters 1 ausgeführt werden, der mehrere Testfinger 2 aufweist, welche jeweils mit einer Prüfsonde 3 versehen sind, mit welcher eine zu testende Leiterplatte 4 elektrisch kontaktiert werden kann, um in den Leiterbahnen ein entsprechendes Messsignal einzuspeisen bzw. abzugreifen (Figur 1).

Solche Prüfsonden 3 sind z. B. in der WO 03/048787 A1 beschrieben, auf welche diesbezüglich Bezug genommen wird.

Im vorliegenden Ausführungsbeispiel weist der Fingertester zwei Traverseneinheiten 5 auf, an welchen mehrere Führungsschienen 6 angeordnet sind, die sich über einen Prüfbereich erstrecken, in dem die zu testende Leiterplatte 4 aufgenommen werden kann. Eine jede Traverseneinheit 5 bildet einen Rahmen mit einer langgestreckten Durchgangsöffnung. Die beiden Traverseneinheiten 5 stehen senkrecht auf einer Halterung 7, so dass deren Durchgangsöffnungen fluchten. Durch die Durchgangsöffnungen der Traverseneinheiten 5 erstreckt sich der Prüfbereich zur Aufnahme der Leiterplatte 4. Im vorliegenden Ausführungsbeispiel weist jede Traverseneinheit vier Führungsschienen 6 auf, wobei jeweils zwei auf jeder Seite der Traverseneinheit 5 angeordnet sind. Auf jeder Seite der Traverseneinheit befindet sich jeweils eine der Führungsschienen 6 oberhalb und die andere der Führungsschienen unterhalb der Durchgangsöffnung 8.

Auf jeder Führungsschiene 6 ist zumindest ein Schlitten 9 verschieblich angeordnet, welcher jeweils einen der Testfinger 2 trägt. Im vorliegenden Ausführungsbeispiel sind auf einer Führungsschiene 6 jeweils zwei Schlitten 9 vorgesehen. Grundsätzlich können jedoch auch mehr als zwei Schlitten 9 auf einer Führungsschiene 6 angeordnet sein.

Die Testfinger 2 sind an einem Ende schwenkbar an den Schlitten 9 befestigt. Ein solcher Aufbau eines Fingertesters geht beispielsweise aus der WO 2014/140029 A1 hervor. Diesbezüglich wird auf dieses Dokument vollinhaltlich Bezug genommen.

Die Prüfsonden 3 sind an den von den Schlitten 9 entfernten Enden, den freien Enden der Testfinger 2 angeordnet und weisen jeweils eine Prüfnadel 10 auf, welche mit einer Kontaktspitze 11 in Richtung zur zu kontaktierenden Leiterplatte 4 gerichtet ist. Die Testfinger 2 können mit den Prüfsonden 3 in Richtung zur Leiterplatte 4 und weg von der Leiterplatte 4 bewegt werden, um die Kontaktspitze 11 entweder auf der Oberfläche der Leiterplatte anzuordnen oder in eine Bohrung in der Leiterplatte 4 einzuführen.

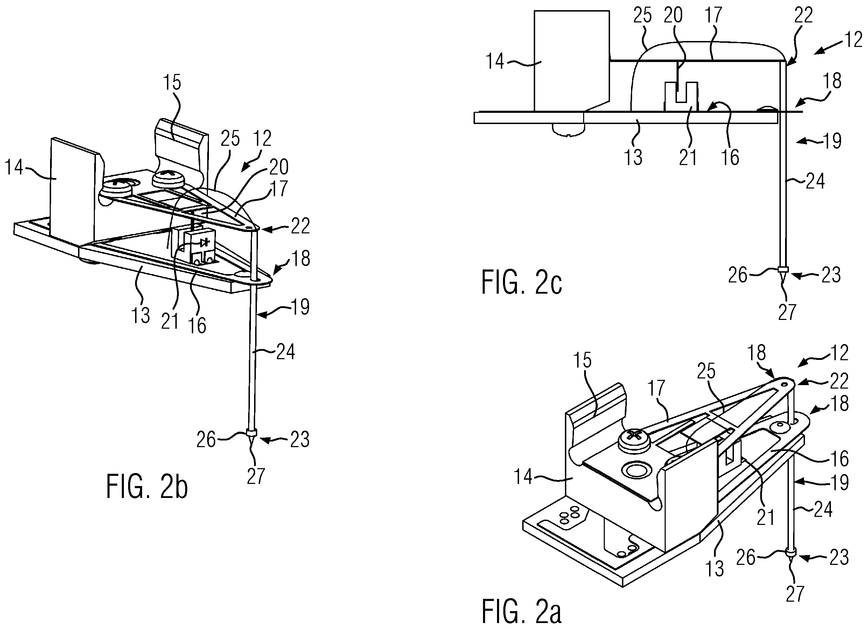

Erfindungsgemäß weist zumindest einer der Testfinger 2 oder mehrere der Testfinger 2 jeweils eine Prüfsonde 12 auf (Figur 2a-2c), welche zum berührungsfreien, kapazitiven Abtasten von Bohrungen und insbesondere von Sacklochbohrungen der Leiterplatte 4 ausgebildet ist. Eine solche Prüfsonde 12 weist ein Basisplättchen 13 auf, das als Leiterplatte ausgebildet ist. Auf dem Basisplättchen 13 ist ein Rastkörper 14 angeordnet, welcher zwei Rastarme 15 aufweist, mit welchen die Prüfsonde 12 an einem der Testfinger 2 rastend fixiert werden kann. Am Rastkörper 14 sind zwei Federarme 16, 17 befestigt. Einer der beiden Federarme liegt unmittelbar auf dem Basisplättchen 13 auf und ist zwischen dem Basisplättchen 13 und dem Rastkörper 14 eingeklemmt. Der andere Federarm 17 ist an der vom Basisplättchen 13 entfernten Oberfläche des Rastkörpers 14 mittels zweier Schrauben befestigt. Die Federarme 16, 17 sind zueinander parallel angeordnet. Von dem Rastkörper 14 ausgehend verjüngen sich in der Draufsicht das Basisplättchen 13 und die Federarme 16, 17 zu einem freien Ende 18, an dem die beiden Federarme 16, 17 jeweils ein Stück vorstehen. An diesen Enden der Federarme 16, 17 ist jeweils eine Prüfnadel 19 befestigt, sodass die elastischen Federarme 16, 17, der Rastkörper 14 und der die beiden Federarme 16, 17 verbindende Abschnitt der Prüfnadel 19 ein Parallelogramm bilden. Die beiden Federarme 16, 17 können mit ihren freien Enden von dem Basisplättchen 13 weggeschwenkt werden, so dass die Prüfnadel an der Prüfsonde 12 elastisch gelagert ist. Der unmittelbar am Basisplättchen anliegende Federarm 16 wird im Folgenden als Basisfederarm 16 und der vom Basisplättchen 13 entfernte Federarm 17 als freier Federarm 17 bezeichnet. Das Basisplättchen 13 bildet somit einen Anschlag für den Basisfederarm 16 und damit für die Bewegung der Prüfnadel 19 relativ zum übrigen Körper der Prüfnadel 12.

Beide Federarme 16, 17 bilden in der Draufsicht einen etwa dreieckförmigen Rahmen. Am freien Federarm 17 ist eine zum Basisplättchen 13 zeigende Messfahne 20 angeordnet.

Auf dem Basisplättchen 13 befindet sich eine Lichtschrankenanordnung 21, welche mit einer Lichtquelle und einem Lichtsensor eine Lichtschranke ausbildet, in welche die Messfahne 20 eingreift, wenn die Federarme 16, 17 nicht ausgelenkt sind. Beim Auslenken der Federarme wird die Messfahne 20 aus der Lichtschranke bewegt, so dass der Lichtsensor eine größere Helligkeit detektiert. Diese Lichtschrankenanordnung 21 bildet somit zusammen mit der Messfahne 20 einen Berührungssensor, welche detektiert, wenn durch Berührung der Prüfnadel 19 mit einem anderen Körper die Federarme 16, 17 ausgelenkt werden.

Die Prüfnadel weist ein Anschlussende 22 und ein Messende 23 auf. Im Bereich des Anschlussendes 22 ist der freie Federarm 17 mit der Prüfnadel 19 verbunden. Die Prüfnadel 19 ist mit dem Basisfederarm 16 so verbunden, dass im nicht-ausgelenkten Zustand der Federarme 16, 17, also wenn der Basisfederarm 16 auf dem Basisplättchen 13 aufliegt, die Prüfnadel 19 senkrecht zur Ebene des Basisplättchens 13 angeordnet ist.

Diese Prüfsonde 12 und der korrespondierende Testfinger 2 sind derart ausgebildet, dass im am Testfinger 2 montierten Zustand die Prüfnadel im nicht-ausgelenkten Zustand senkrecht zum Prüfbereich bzw. zu einer im Prüfbereich befindlichen Leiterplatte 4 angeordnet ist.

Die Prüfnadel 19 steht an der Prüfsonde 12 ein Stück bezüglich des Basisplättchens 13 vor.

Die Prüfnadel 19 weist ein Metallröhrchen auf, das elektrisch leitend ist und einen Außendurchmesser von vorzugsweise maximal 0,2 mm und insbesondere maximal 0,18 mm aufweist. Im Metallröhrchen 24 ist ein Kabel 25 geführt, das einen elektrischen Leiter aufweist, der von einer Isolationsschicht umgeben ist. Das Kabel 25 ist im vorliegenden Ausführungsbeispiel mit einer am Basisplättchen 13 ausgebildeten Leiterbahn verbunden, welche elektrisch mit einer kapazitiven Messeinrichtung (nicht dargestellt) verbunden ist. Am Messende 23 ist der Leiter des Kabels 25 mit einem kapazitiven Messkörper 26 verbunden. Der kapazitive Messkörper ist ein metallischer Ringkörper, der um das Röhrchen herum angeordnet und von diesem elektrisch isoliert ist. Der kapazitive Messkörper 26 kann ein mit einer Isolationsschicht versehener Metallring sein, der elektrisch mit dem Leiter des Kabels 25 verbunden ist. Der kapazitive Messkörper 26 kann in einem nicht beanspruchten Beispiel jedoch auch aus einer oder mehreren Wicklungen des Kabels 25 ausgebildet sein.

Das Metallröhrchen 24 dient zur Abschirmung des Kabels 25, so dass alleine der kapazitive Messkörper 26 eine kapazitive Kopplung mit einem sich in der Nähe befindlichen elektrischen Leiter eingehen kann und alleine dessen kapazitive Kopplung zu diesem weiteren elektrischen Leiter mittels des Kabels 25 abgetastet werden kann.

Am Messende 23 der Prüfnadel 19 ist eine Messspitze 27 ausgebildet. Diese Messspitze dient in einem nicht beanspruchten Beispiel lediglich zur mechanischen Berührung eines anderen Körpers. Die Messspitze kann dazu aus einem nicht-elektrisch leitenden Material ausgebildet oder mit einer Isolationsschicht versehen sein. Im vorliegenden Beispiel dient sie nicht zur elektrischen Kontaktierung einer Kontaktstelle einer Leiterplatte.

Im Rahmen der Erfindung ist die Messspitze auch elektrisch leitend ausgebildet, so dass sie zur Herstellung einer elektrischen Verbindung mit einer Kontaktstelle der Leiterplatte verwendet werden kann. Ist eine solche elektrisch leitende Kontaktspitze mit dem kapazitiven Messkörper 26 elektrisch verbunden, dann kann die Kontaktspitze bei einer kapazitiven Kopplung, die der kapazitiven Messkörper 26 mit einem zu vermessenden elektrisch leitenden Gegenstand ausbildet, mit berücksichtigt werden.

Ein Ausführungsbeispiel der Messspitze 27 ist aus einem Kanüle-Röhrchen 28 ausgebildet, das mit einem Ende mittels einer Lötverbindung 29 mit dem Röhrchen bzw. Abschirmung 24 elektrisch leitend und mechanisch verbunden ist. Das Kanüle-Röhrchen weist im Bereich der Lötverbindung 29 einen Durchmesser von beispielsweise 0,3 mm auf. Das Kanüle-Röhrchen ist axial in Richtung zur Messspitze 27 ausgebildet und besitzt im Bereich der Messspitze 27 einen Durchmesser von 0,2 mm oder weniger. Das Kanüle-Röhrchen 28 ist im Bereich der Messspitze schräg angeschnitten, sodass sich eine schräg verlaufenden Austrittsöffnung 30 ergibt.

Das Kabel 25 wird durch das Röhrchen 24 und das Kanüle Röhrchen 28 geführt und tritt bei der Austrittsöffnung 30 aus dem Kanüle-Röhrchen 28 aus. Im Bereich der Messspitze 27 ist das Kabel mit z. B. drei Wicklungen um das Kanüle-Röhrchen 28 gewickelt und bildet den kapazitiven Messkörper 26.

Die Messspitze 27 selbst ist elektrisch leitend und elektrisch leitend mit dem Röhrchen 24 verbunden.

Eine solch elektrisch leitend ausgebildete Messspitze hat den Vorteil, dass die Prüfnadel 19 beispielsweise mit einer Kalibrieroberfläche in Kontakt treten kann, welche elektrisch leitende und nicht elektrisch leitende Oberflächenabschnitte aufweist, sodass die Position der Prüfnadel 19 und damit die Position eines Testfingers 2, in dem die Prüfnadel 19 befestigt ist, kalibriert werden kann.

Die in Figur 3 gezeigte Prüfnadel 19 ist einfach zu fertigen und weist einen sehr kleinen Messkörper 26 auf, sodass die Ortsauflösung entsprechend präzise ist.

Ein typischer Messvorgang zum Messen der elektrisch leitenden Beschichtung in einer Sacklochbohrung einer Leiterplatte mittels des Fingertesters 1 läuft folgendermaßen ab:
- Mit einem Testfinger 2, der die erfindungsgemäße Prüfsonde 12 aufweist, wird zunächst die Oberfläche der zu testenden Leiterplatte 4 mechanisch kontaktiert, um deren Höhe zu bestimmen.
- Die Prüfsonde wird mit der Prüfnadel in eine zu vermessende Sacklochbohrung der Leiterplatte 4 eingeführt, bis die Messspitze 27 den Boden der Sacklochbohrung der Leiterplatte 4 berührt. Der Ort der Prüfsonde 12 zu dem Zeitpunkt, wenn der Boden der Sacklochbohrung berührt, wird mittels des Berührungssensors erfasst, so dass aus der Höhendifferenz zwischen diesem Ort und dem Ort, an dem mit der Prüfsonde bzw. mit deren Messspitze 27 die Oberfläche der Leiterplatte berührt worden ist, die Tiefe der Sacklochbohrung ermittelt wird.
- Mit dem in der Sacklochbohrung befindlichen kapazitiven Messkörper 26 wird eine kapazitive Messung der Kapazität zwischen dem kapazitiven Messkörper 26 und einem sich in der Sacklochbohrung befindlichen elektrischen Leiter ausgeführt, indem mittels eines weiteren Testfingers 2, der eine Kontaktstelle der Leiterplatte kontaktiert, die mit diesem elektrischen Leiter verbunden ist, an diesen elektrischen Leiter ein vorbestimmtes Messsignal anlegt wird. Das Messsignal weist vorzugsweise eine Frequenz von zumindest 1 kHz und insbesondere eine Frequenz von zumindest 4 kHz bzw. zumindest 10 kHz auf.

Das hierdurch auf den kapazitiven Messkörper 26 induzierte Signal wird mittels des Kabels 25 von dem kapazitiven Messkörper 26 abgegriffen und zu der Messeinrichtung weitergeleitet. Anhand der Amplitude des so gemessenen Signals kann die ausgebildete Kapazität zwischen dem kapazitiven Messkörper 26 und dem hierzu benachbart angeordneten elektrischen Leiter bestimmt werden. Gleichzeitig wird der Ort des kapazitiven Messkörpers 26 erfasst, der durch den Ort der Prüfsonde 12 vorgegeben ist, welcher durch die Bewegung des entsprechenden Testfingers 2 eingestellt wird und am Fingertester 1 bekannt ist. Durch das gleichzeitige Erfassen des Ortes und der Kapazität beim Bewegen des kapazitiven Messkörpers 26 in der Sacklochbohrung kann die Kapazität, die der kapazitive Messkörper 26 mit seiner Umgebung ausbildet, ortsabhängig festgestellt werden. Hierdurch wird ein Profil der Kapazität erzeugt, aus dem die Beschichtung der Innenfläche der Sacklochbohrung mit einem elektrischen Leiter abgeleitet werden kann.

Vorzugsweise weist der Fingertester 1 mehrere Testfinger 2 auf, welche jeweils mit einer erfindungsgemäßen Prüfsonde 12 versehen sind. Hierdurch können mehrere Sacklochbohrungen oder Durchgangsbohrungen gleichzeitig vermessen werden. Vorzugsweise werden beim gleichzeitigen Messen Messsignale verwendet, die sich in ihrer Frequenz unterscheiden. Hierdurch kann dann mit entsprechenden Bandpassfiltern ein Übersprechen von einer Messung auf eine andere Messung verhindert werden.

Vorzugsweise sind auf jeder Führungsschiene 6 zumindest ein Testfinger 2 mit einer Prüfsonde 3 mit einer herkömmlichen Prüfnadel 10 zum elektrischen Kontaktieren einer Kontaktstelle der Leiterplatte und ein weiterer Testfinger 2 mit einer erfindungsgemäßen Prüfsonde 12 vorgesehen. Es kann auch zweckmäßig sein, auf einer Führungsschiene 6 zwei Testfinger 2 mit herkömmlichen Prüfsonden 3 und einen weiteren Testfinger 2 mit einer erfindungsgemäßen Prüfsonde 12 vorzusehen.

Die Erfindung kann jedoch auch auf einem herkömmlichen Fingertester angewendet werden, der mehrere separate Traversen aufweist, die nicht auf einer gemeinsamen Traverseneinheit 5 angeordnet sind. Bei einem solchen Fingertester ist es wiederum zweckmäßig, pro Traverse zumindest einen Testfinger 2 mit einer erfindungsgemäßen Prüfsonde 12 und ein oder mehrere Testfinger mit herkömmlichen Prüfsonden 3 vorzusehen.

Mit der erfindungsgemäßen Prüfsonde lässt sich somit sehr einfach und präzise die Geometrie einer Sacklochbohrung oder Durchgangsbohrung bestimmen und andererseits die Beschichtung mit einem elektrischen Leiter der Innenfläche der Sacklochbohrung oder Durchgangsbohrung feststellen.

Weiterhin kann die erfindungsgemäße Prüfsonde 12 in herkömmliche Fingertester (englisch: Flying Probe Tester) eingesetzt werden. Es sind keine weiteren mechanischen Umbauten notwendig. Lediglich muss der Fingertester mit einem geeigneten Steuerprogramm versehen werden, das die von der erfindungsgemäßen Prüfsonde 12 erzeugten Messsignale verarbeiten und geeignete Messsignale anlegen kann und die Bewegung eines Testfingers 2 mit der erfindungsgemäßen Prüfsonde 12 steuern kann.

Nachfolgend wird ein Verfahren zum Messen einer Durchkontaktierung 31 in einer Bohrung 37 einer Leiterplatte 38 erläutert. Die Durchkontierung 31 ist eine elektrisch leitende Beschichtung an der inneren Oberfläche der Bohrung. Beim Herstellen der Leiterplatte 38 wird zunächst die gesamte Bohrung beschichtet. Danach wird die Bohrung ein zweites Mal ein Stück tief nachgebohrt, so dass in einem vorbestimmten Abschnitt die Beschichtung der Bohrung 37 wieder entfernt wird. Hierbei können Fehler entstehen, wenn das Nachbohren entweder nicht ausreichend tief oder zu tief durchgeführt worden ist, so dass der Rand der Beschichtung in der Bohrung ein Stück gegenüber seiner gewünschten Position versetzt ist. Die zweite Bohrung kann auch ein Stück versetzt zur ersten Bohrung erfolgen, so die beiden Bohrungen nicht konzentrisch sind. Hierdurch verbleibt ein dünner unerwünschter Streifen (Engl.: stripe) der Beschichtung im Bereich der Bohrung. Der Streifen erstreckt sich in eine Richtung etwa parallel zur Mittelachse der Bohrung. Ein solcher Streifen kann auch entstehen, wenn die zweite Bohrung bzgl. der ersten Bohrung etwas schräg ausgeführt wird.

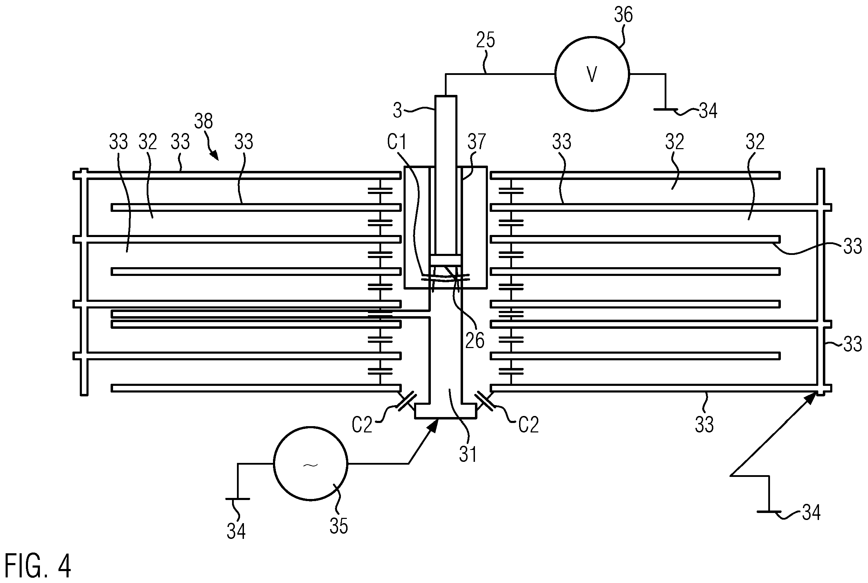

Die Leiterplatte 38 weist mehrere Lagen 32 auf, zwischen welchen Leiterbahnen 33 ausgebildet sind. Es gibt größere und kleinere Leiterbahnen. In der Regel ist die sogenannte Masseleiterbahn die größte Leiterbahn einer Leiterplatte und kann sich oftmals über mehrere Lagen 32 hinweg erstrecken. Beim nachfolgend erläuterten Messverfahren wird die Masseleiterbahn mit der elektrischen Erde 34 verbunden (Fig. 4). An Stelle der einzelnen Masseleiterbahnen können auch mehrere einzelne kleinere Leiterbahnen verwendet werden, die gleichzeitig mit der elektrischen Erde 34 verbunden werden. Für die nachfolgende Beschreibung wird der Begriff der "Masseleiterbahn" zur Beschreibung einer oder mehrerer Leiterbahnen verwendet, welche gleichzeitig mit elektrischer Erde verbindbar sind und sich über einen größeren Bereich der Leiterplatte 38, insbesondere über mehrere Lagen verzweigen. Diese Verbindung zur elektrischen Erde 34 erfolgt vorzugsweise durch Anlegen eines beweglichen Kontaktfingers des Fingertesters an die Leiterbahn, wobei dieser Kontaktfinger eine elektrische leitende Kontaktspitze aufweist, welche mit der elektrischen Erde verbunden ist.

Beim Einführen der Prüfsonde 3 in die Bohrung bildet der kapazitive Messkörper 26 mit den umliegenden elektrischen Leitern eine elektrische Kapazität aus. Ziel dieses Verfahrens ist es diese Kapazität bzw. deren Änderung beim Einführen des kapazitiven Messkörpers in die Bohrung zu messen.

Hierzu wird mit einem Signalgenerator 35 ein Schwingungssignal gegenüber der elektrischen Erde an der Durchkontaktierung 31 angelegt. Dieses Messsignal fliest entlang der Durchkontaktierung 31, über eine Kapazität C1 zwischen der Durchkontaktierung 31 und dem kapazitiven Messkörper 26 in den kapazitiven Messkörper 26 und von dort über das Kabel 25 zu einem Strommessgerät 36, mit welchem die Spannung und damit die Kapazität C1 bzw. dessen Kapazitätsänderung, wenn der kapazitive Messkörper 26 in die Nähe der Durchkontaktierung 31 gelangt, gemessen werden.

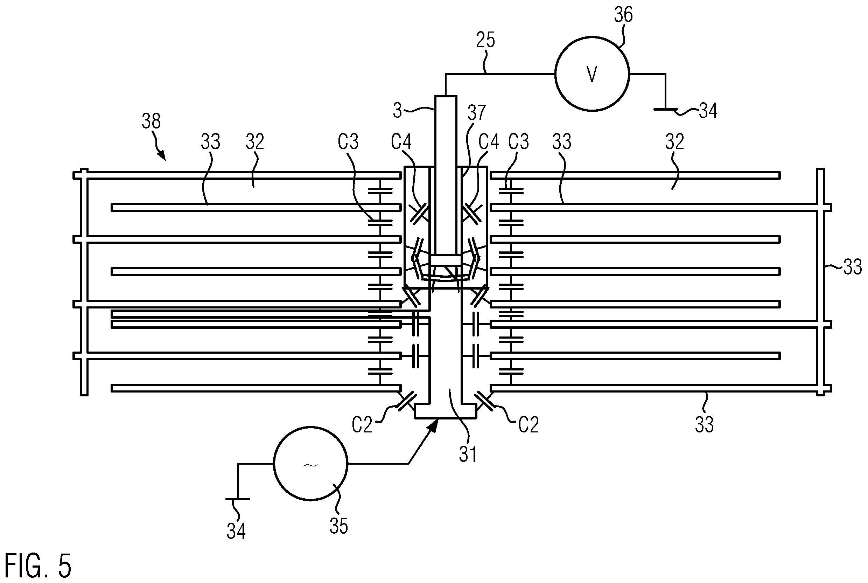

Zwischen der Durchkontaktierung 31 und den benachbarten Leiterbahnen bildet sich eine parasitäre Kapazität C2 aus. Diese ist vor allem dann relevant, wenn sie sich zwischen der Durchkontaktierung und der Masseleiterbahn bildet. Würde die Masseleiterbahn nicht geerdet sein, dann würde sich über die parasitäre Kapazität das Messsignal auf weitere Leiterbahnen über deren kapazitive Kopplung (Kapazität C3) zu der Masseleiterbahn übertragen. Dadurch würde man mit dem kapazitiven Messkörper das Messsignal über weitere kapazitive Kopplungen (Kapazität C4) zwischen dem kapazitiven Messkörper 26 und den außerhalb der Durchkontaktierung angeordneten Leiterbahnen sehen (Fig. 5). Hierdurch könnte man nicht genau feststellen, ob man die elektrische Kapazität C1 zwischen dem Messkörper 26 und der Durchkontaktierung 31 oder die Kapazität C4 zwischen dem Messkörper 26 und einer der weiteren Leiterbahnen misst.

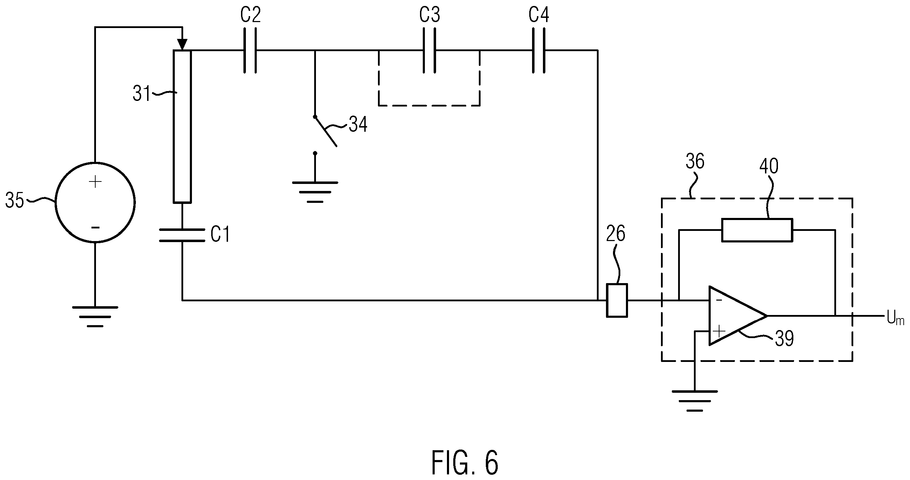

Nachfolgend wird anhand eines Ersatzschaltbildes (Fig. 6) die Funktionsweise der Messanordnung aus Fig. 4 und 5 erläutert. Dieses Ersatzschaltbild umfasst folgende Elemente:
26 Messkörper
31 Durchkontaktierung
34 elektrische Erde (= Erdungsfinger, schaltbar)
35 Signalgenerator
36 Strommessgerät

Der Kondensator C1 stellt die Kopplung zwischen der Durchkontaktierung 31 und dem Messkörper 26 dar.

Der Kondensator C2 befindet sich zwischen der Durchkontaktierung 31 und der Masseleiterbahn im Sinne der obigen Beschreibung. Der Kondensator C3 ist die Kopplung zwischen der Masseleiterbahn und den weiteren Leiterbahnen. Der Kondensator C4 stellt die Kopplung der Leiterbahnen mit dem Messkörper 26 dar. Die Kopplung der Leiterbahnen mit dem Messkörper 26 kann unmittelbar durch die Masseleiterbahn oder durch über die Kapazität C3 mit der Masseleiterbahn gekoppelte weitere Leiterbahnen erfolgen. Wenn die Kopplung unmittelbar zwischen der Masseleiterbahn und dem Messkörper 26 besteht, dann entfällt der Kondensator C3, weshalb er mit einer gestrichelten Linie im Ersatzschaltbild kurzgeschlossen ist und bei der weiteren Betrachtung nicht berücksichtigt werden müsste.

Die Verbindung 34 der Masseleiterbahn zur elektrischen Erde ist mit einem Schalter im Ersatzschaltbild (Fig. 6) dargestellt, wobei gemäß der Messanordnung nach Figur 4 der Schalter geschlossen und gemäß der Messanordnung nach Fig. 5 der Schalter offen ist.

Ist die Masseleiterbahn nicht mit der elektrischen Erde verbunden (Schalter bei 34 in Fig. 6 ist offen), dann gilt Folgendes:
Die Kondensatoren C2(, C3), C4 sind parallel zum Kondensator C1 geschaltet. Ist die Reihenschaltung aus C2(, C3), C4 größer als C1, dann wird die Gesamtkapazität zwischen der Durchkontaktierung 31 und dem Messkörper 26 vor allem durch die Reihenschaltung der Kondensatoren C2(, C3), C4 bestimmt und der vom Strommessgerät 36 gemessene Strom wird vor allem von der Reihenschaltung aus C2(, C3), C4 bestimmt.

Ist die Masseleiterbahn mit der elektrischen Erde verbunden (Schalter bei 34 in Fig. 6 ist geschlossen), dann ist die Verbindung zwischen C2 und C3 mit der elektrischen Erde verbunden.

Das Strommessgerät 36 ist ein Strom-Spannungswandler, das einen Operationsverstärker 39 sowie einen Messwiderstand 40 aufweist. Der Operationsverstärker ist bspw. vom Typ AD549. Am Ausgang des Strommessgeräts 36 liegt ein Spannungssignal Uₘ an, das proportional zu dem am Eingang des Strommessgerätes fliesenden Stromes ist.

Ein Eingang des Operationsverstärkers ist mit dem Messkörper 26 und der andere Eingang mit der elektrischen Erde verbunden. Durch eine Rückkopplung der Eingangs- und der Ausgangsseite des Operationsverstärkers über den Messwiderstand 40 werden beide Eingänge des Operationsverstärkers 39 auf dem Potential der elektrischen Erde gehalten.

Die Kondensatoren C3 und C4 sind somit zwischen zwei Punkten angeordnet, welche jeweis auf dem Potential der elektrischen Erde liegen, so dass durch sie kein Strom fließt. Sie sind somit in der Messung nicht sichtbar.

An einer Seite des Kondensators C2 liegt das Spannungssignal des Signalgenerators 35 an und die andere Seite des Kondensators C2 ist mit der elektrischen Erde verbunden, so dass durch diesen Kondensator ein Strom fließt. Dieser Strom wird vom Messgerät nicht gemessen, da er unmittelbar auf die elektrische Erde abfließt. Dieser Strom beeinflusst die vom Signalgenerator 35 abgegebene Leistung, jedoch nicht die vom Signalgenerator 35 abgegebene Spannung. Da das am Kondensator C1 anliegende Spannungssignal U und der durch den Kondensator fließende Strom I bekannt sind, kann hieraus die Kapazität des Kondensators C1 bestimmt werden, ohne dass die Messung durch die weiteren Kapazitäten C2, C3, C4 beeinflusst wird, wenn die Masseleiterbahn mit der elektrischen Erde verbunden ist.

Hierdurch kann durch Verbinden der Masseleiterbahn mit der elektrischen Erde die kapazitive Kopplung C1 zwischen dem Messkörper 26 und der Durchkontaktierung 31 exakt gemessen werden, wobei der Betrag der kapazitiven Kopplung C1 bestimmt werden kann und eine Aussage über die geometrische Größe eines Fehlers an der Durchkontaktierung erlaubt.

Dieses Verfahren ist so präzise, dass es auch so abgewandelt werden kann, dass das Signal des Signalgenerators an eine einzelne Leiterbahn angelegt werden kann, die sich bis an die Durchgangsbohrung erstreckt, so dass anhand dieses Signals die kapazitive Kopplung des Messkörpers zu dieser Leiterbahn detektiert werden kann. Hierdurch kann die Position des Messkörpers in der Durchgangsbohrung bestimmt werden bzw. es kann bestimmt werden, dass diese Leiterbahn das Messsignal korrekt bis an den Bereich der Durchkontaktierung leitet.

Üblicherweise wird der Ort der Prüfsonde relativ zum Ort der zu testenden Leiterplatte kalibriert, indem die Prüfsonde 12 mit ihrer Kontaktspitze mit der Oberfläche der Leiterplatte in Berührung gebracht wird. Diese mechanische Kalibrierung kann durch eine elektrische Kalibrierung ersetzt werden, wobei bei der elektrischen Kalibrierung ein Schwingungssignal an eine an die Durchgangsbohrung angrenzende Leiterbahn angelegt wird, das dann von der Prüfsonde bzw. deren Messkörper erfasst wird.

Dieses Verfahren kann auch dahingehend abgewandelt werden, dass mehrere Messsignale mit unterschiedlichen Frequenzen an unterschiedliche Leiterbahnen und/oder die Durchkontaktierung angelegt werden. Die unterschiedlichen Frequenzen werden bei der Messung unterschieden. Dies kann bspw. dadurch erfolgen, dass dem Strommessgerät 36 ein abstimmbarer Bandpassfilter vorgeschaltet ist, der jeweils auf ein Frequenzband geschaltet werden kann, das jeweils eine Frequenz eines der Signale umfasst. Hierdurch lassen sich im Bereich einer Durchgangsbohrung mehrere Leiterbahnen detektieren, sofern sie nicht durch eine Durchkontaktierung abgeschirmt sind.

### Bezugszeichenliste

- 1: Fingertester
- 2: Testfinger
- 3: Prüfsonde
- 4: Leiterplatte
- 5: Traverseneinheit
- 6: Führungsschiene
- 7: Halterung
- 8: Durchgangsöffnung
- 9: Schlitten
- 10: Prüfnadel
- 11: Kontaktspitze
- 12: Prüfsonde
- 13: Basisplättchen
- 14: Rastkörper
- 15: Rastarm
- 16: Federarm (Basisfederarm)
- 17: Federarm (freier Federarm)
- 18: freies Ende
- 19: Prüfnadel
- 20: Messfahne
- 21: Lichtschrankenanordnung
- 22: Anschlussende
- 23: Messende
- 24: Röhrchen
- 25: Kabel
- 26: kapazitiver Messkörper
- 27: Messspitze
- 28: Kanüle-Röhrchen
- 29: Lötverbindung
- 30: Austrittsöffnung
- 31: Durchkontaktierung
- 32: Lage
- 33: Leiterbahn
- 34: elektrische Erde
- 35: Signalgenerator
- 36: Strommessgerät
- 37: Bohrung
- 38: Leiterplatte
- 39: Operationsverstärker
- 40: Messwiderstand

## Patentansprüche

1. Prüfnadel zum Messen von elektrisch leitenden Schichten in Bohrungen von Leiterplatten, umfassend
einen elektrischen Leiter, welcher von einer Abschirmung (24) umgeben ist, wobei die Prüfnadel (19) ein Anschlussende (22), an welchem sie mit einer kapazitiven Messeinrichtung elektrisch verbindbar ist, und ein Messende (23) aufweist, das bei einer Messung in eine Bohrung einführbar ist,
wobei am Messende (23) ein mit dem elektrischen Leiter verbundener kapazitiver Messkörper (26) außerhalb der Abschirmung (24) angeordnet ist, welcher mit einer elektrisch leitenden Schicht in der Bohrung eine kapazitive Kopplung ausbilden kann,
**dadurch gekennzeichnet,**
**dass** der Messkörper (26) in der Form eines Hohlzylinders ausgebildet ist und am Messende (23) der Prüfnadel (27) eine elektrisch leitende Messspitze (27) ausgebildet ist.

2. Prüfnadel nach Anspruch 1,
**dadurch gekennzeichnet,**
**dass** der Messkörper (26) mit einer elektrischen Isolationsschicht umgeben ist.

3. Prüfnadel nach Anspruch 1 oder 2,
**dadurch gekennzeichnet,**
**dass** die Prüfnadel (19) ein elektrisch leitendes Röhrchen (24) aufweist, welches die Abschirmung bildet, in welchem ein Kabel (25), das den elektrischen Leiter und eine elektrische Isolationsschicht umfasst, geführt ist, wobei das Kabel (25) am Anschlussende (22) aus dem Röhrchen (24) ein Stück vorsteht, um an die kapazitive Messeinrichtung angeschlossen zu werden.

4. Prüfsonde zum Messen von elektrisch leitenden Schichten in Bohrungen von Leiterplatten, mit
einer Prüfnadel (12) nach einem der Ansprüche 1 bis 3, und
einen Berührungssensor (20, 21), mit welchem feststellbar ist, ob die Prüfnadel (12) einen anderen Körper berührt.

5. Prüfsonde nach Anspruch 4,
**dadurch gekennzeichnet,**
**dass** der Berührungssensor (20, 21) eine federelastische Halterung (16, 17) zum Halten der Prüfnadel (12) und einen Sensor zum Detektieren einer Auslenkung der federelastischen Halterung (16, 17) aufweist.

6. Prüfsonde nach Anspruch 5,
**dadurch gekennzeichnet,**
**dass** der Sensor zum Detektieren einer Auslenkung der federelastischen Halterung (16, 17) ein optischer Sensor, insbesondere eine Lichtschrankenanordnung (21) ist.

7. Prüfsonde nach Anspruch 5 oder 6,
**dadurch gekennzeichnet,**
**dass** an der Prüfsonde (12) ein Anschlag (13) ausgebildet ist, an welchem die Prüfnadel (19) und/oder die federelastische Halterung (16, 17) im nicht ausgelenkten Zustand anliegt.

8. Fingertester zum Testen von Leiterplatten, insbesondere zum Testen von unbestückten Leiterplatten, mit zumindest einem Testfinger (2), welcher frei in einem vorbestimmten Prüfbereich bewegbar ist, um in die Nähe einer vorbestimmten Kontaktstelle der Leiterplatte (4) angeordnet werden zu können, wobei der Testfinger eine Prüfnadel nach einem der Ansprüche 1 bis 3 oder eine Prüfsonde nach einem der Ansprüche 4 bis 7 aufweist.

9. Fingertester nach Anspruch 8,
**dadurch gekennzeichnet,**
**dass** der Fingertester (1) mehrere Testfinger (2) aufweist, wobei einer oder mehrere der Testfinger mit einer Prüfnadel (10) zum elektrischen Kontaktieren von vorbestimmten Kontaktstellen der Leiterplatte (4) ausgebildet ist.

10. Verfahren zum Messen von elektrisch leitenden Schichten in Bohrungen von Leiterplatten, wobei ein Fingertester nach Anspruch 8 oder 9 verwendet wird, die Prüfnadel mit dem kapazitiven Messkörper (26) in eine Bohrung eingeführt wird, wobei der Ort des kapazitiven Messkörpers (26) erfasst wird und gleichzeitig die elektrische Kapazität des kapazitiven Messkörpers (26) zu seiner Umgebung gemessen wird, so dass anhand der gemessenen Kapazität bestimmt wird, ob in der Nähe des erfassten Ortes sich ein elektrischer Leiter befindet.

11. Verfahren nach Anspruch 10,
**dadurch gekennzeichnet,**
**dass** zum Messen der Kapazität an eine Leiterbahn, welche einen elektrisch leitenden Abschnitt im Bereich der zu vermessenden Bohrung aufweist und/oder an den Messkörper (26) ein elektrisches Signal mit einer Frequenz von zumindest 1 kHz angelegt wird.

12. Verfahren nach Anspruch 10 oder 11,
**dadurch gekennzeichnet,**
**dass** das Bestimmen, ob ein elektrischer Leiter sich in der Nähe des Messkörpers (26) befindet, durch einen Vergleich mit einem Kapazitätsprofil einer ordnungsgemäßen Bohrung erfolgt.

13. Verfahren nach einem der Ansprüche 10 bis 12,
**dadurch gekennzeichnet,**
**dass** zumindest eine Leiterbahn (33) der Leiterplatte mit der elektrischen Erde verbunden wird, wobei diese Leiterbahn (33) vorzugsweise eine sich weit über die Leiterplatte erstreckende Leiterbahn, wie z.B. eine Masseleiterbahn, ist.

14. Verfahren nach Anspruch 13,
**dadurch gekennzeichnet,**
**dass** zum Messen der elektrischen Kapazität ein Strommessgerät verwendet wird, dessen Eingangsseite auf das Potential der elektrischen Erde gelegt ist.

15. Verfahren nach Anspruch 13 oder 14,
**dadurch gekennzeichnet,**
**dass** an mehreren leitenden Schichten im Bereich einer Durchkontaktierung ein Messsignal angelegt wird, das mit dem Messkörper (26) detektierbar ist, wobei vorzugsweise die mehreren Messsignale Schwingungssignale mit unterschiedlichen Frequenzen sind und bei der Messung die unterschiedlichen Messsignale anhand der unterschiedlichen Frequenzen unterschieden werden.

## Claims

1. A test needle for measuring electrically conductive layers in holes of printed circuit boards, comprising
an electrical conductor, which is enclosed by a shield (24), wherein the test needle (19) has a connecting end (22) at which it can be electrically connected to a capacitive measuring device, and a measuring end (23) which can be inserted into a hole during a measurement,
wherein, at the measuring end (23), a capacitive measuring body (26) connected to the electrical conductor is arranged outside the shield (24) and can form a capacitive coupling with an electrically conductive layer in the hole,
**characterized in that**
the measuring body (26) is designed in the form of a hollow cylinder and an electrically conductive measuring tip (27) is formed at the measuring end (23) of the test needle (19).

2. The test needle according to claim 1,
**characterized in that**
the measuring body (26) is surrounded by an electrical insulation layer.

3. The test needle according to claim 1 or 2,
**characterized in that**
the test needle (19) has an electrically conductive tube (24) which forms the shield, in which tube a cable (25) comprising the electrical conductor and an electrical insulation layer is arranged, wherein the cable (25) protrudes a short distance from the tube (24) at the connecting end (22) in order to be connected to the capacitive measuring device.

4. A test probe for measuring electrically conductive layers in holes of printed circuit boards, comprising
a test needle (12) according to any one of claims 1 to 3, and
a touch sensor (20, 21) by means of which it can be detected whether the test needle (12) is touching another body.

5. The test probe according to claim 4,
**characterized in that**
the touch sensor (20, 21) comprises a spring-elastic mount (16, 17) for holding the test needle (12) and a sensor for detecting a deflection of the spring-elastic mount (16, 17).

6. The test probe according to claim 5,
**characterized in that**
the sensor for detecting a deflection of the spring-elastic mount (16, 17) is an optical sensor, in particular a light barrier assembly (21).

7. The test probe according to claim 5 or 6,
**characterized in that**
a stop (13) is formed on the test probe (12), against which the test needle (19) and/or the spring-elastic mount (16, 17) rests in the non-deflected state.

8. A finger tester for testing printed circuit boards, in particular for testing bare printed circuit boards, having at least one test finger (2) which is freely movable in a predetermined testing area in order to be able to be positioned in the vicinity of a predetermined contact point of the printed circuit board (4), wherein the test finger has a test needle according to any one of claims 1 to 3 or a test probe according to any one of claims 4 to 7.

9. The finger tester according to claim 8,
**characterized in that**
the finger tester (1) has a plurality of test fingers (2), wherein one or more of the test fingers is/are provided with a test needle (10) for electrically contacting predetermined contact points of the printed circuit board (4).

10. A method for measuring electrically conductive layers in holes of printed circuit boards, wherein a finger tester according to claim 8 or 9 is used, the test needle with the capacitive measuring body (26) is inserted into a hole, wherein the location of the capacitive measuring body (26) is detected and at the same time the electrical capacitance of the capacitive measuring body (26) relative to its surroundings is measured, such that based on the measured capacitance it is determined whether an electrical conductor is located in the vicinity of the detected location.

11. The method according to claim 10,
**characterized in that**
for measuring the capacitance, an electrical signal having a frequency of at least 1 kHz is applied to a conductor track which has an electrically conductive portion in the area of the hole to be measured and/or to the measuring body (26).

12. The method according to claim 10 or 11,
**characterized in that**
the determination as to whether an electrical conductor is located in the vicinity of the measuring body (26) is carried out by comparison with a capacitance profile of a proper hole.

13. The method according to any one of claims 10 to 12,
**characterized in that**
at least one conductor track (33) of the printed circuit board is connected to electrical ground, wherein said conductor track (33) is preferably a conductor track extending over a large area of the printed circuit board, such as a ground conductor track.

14. The method according to claim 13,
**characterized in that**
for measuring the electrical capacitance, a current-measuring device is used, the input side of which is at the potential of electrical ground.

15. The method according to claim 13 or 14,
**characterized in that**
a measurement signal is applied to a plurality of conductive layers in the area of a plated through-hole, which measurement signal can be detected by the measuring body (26), wherein preferably the plurality of measurement signals are oscillation signals having different frequencies and, during the measurement, the different measurement signals are distinguished based on the different frequencies.

## Revendications

1. Aiguille de test destinée à mesurer des couches électriquement conductrices dans des trous de cartes de circuits imprimés, comprenant
un conducteur électrique qui est entouré d'un blindage (24), l'aiguille de test (19) présentant une extrémité de raccordement (22) au niveau de laquelle elle peut être reliée électriquement à un dispositif de mesure capacitif, et une extrémité de mesure (23) qui peut être introduite dans un trou lors d'une mesure,
dans laquelle, au niveau de l'extrémité de mesure (23), un corps de mesure capacitif (26) relié au conducteur électrique est disposé à l'extérieur du blindage (24) et peut former un couplage capacitif avec une couche électriquement conductrice dans le trou,
**caractérisée en ce que**
le corps de mesure (26) est réalisé sous la forme d'un cylindre creux et une pointe de mesure électriquement conductrice (27) est formée au niveau de l'extrémité de mesure (23) de l'aiguille de test (19).

2. L'aiguille de test selon la revendication 1,
**caractérisée en ce que**
le corps de mesure (26) est entouré d'une couche d'isolation électrique.

3. L'aiguille de test selon la revendication 1 ou 2,
**caractérisée en ce que**
l'aiguille de test (19) présente un tube électriquement conducteur (24) qui forme le blindage et dans lequel est disposé un câble (25) comprenant le conducteur électrique et une couche d'isolation électrique, le câble (25) dépassant d'une certaine longueur du tube (24) au niveau de l'extrémité de raccordement (22) afin d'être relié au dispositif de mesure capacitif.

4. Sonde de test destinée à mesurer des couches électriquement conductrices dans des trous de cartes de circuits imprimés, comprenant
une aiguille de test (12) selon l'une quelconque des revendications 1 à 3, et
un capteur de contact (20, 21) au moyen duquel il est possible de détecter si l'aiguille de test (12) touche un autre corps.

5. La sonde de test selon la revendication 4,
**caractérisée en ce que**
le capteur de contact (20, 21) comprend un support à élasticité de ressort (16, 17), destiné à maintenir l'aiguille de test (12), et un capteur destiné à détecter une déviation du support à élasticité de ressort (16, 17).

6. La sonde de test selon la revendication 5,
**caractérisée en ce que**
le capteur destiné à détecter une déviation du support à élasticité de ressort (16, 17) est un capteur optique, en particulier un agencement de barrière photoélectrique (21).

7. La sonde de test selon la revendication 5 ou 6,
**caractérisée en ce qu'**
une butée (13) est formée sur la sonde de test (12), contre laquelle l'aiguille de test (19) et/ou le support à élasticité de ressort (16, 17) s'appuie dans l'état non dévié.

8. Testeur à doigts destiné à tester des cartes de circuits imprimés, en particulier à tester des cartes de circuits imprimés non équipées, comportant au moins un doigt de test (2) qui est librement déplaçable dans une zone de test prédéterminée afin de pouvoir être positionné à proximité d'un point de contact prédéterminé de la carte de circuits imprimés (4), le doigt de test présentant une aiguille de test selon l'une quelconque des revendications 1 à 3 ou une sonde de test selon l'une quelconque des revendications 4 à 7.

9. Le testeur à doigts selon la revendication 8,
**caractérisé en ce que**
le testeur à doigts (1) comporte une pluralité de doigts de test (2), un ou plusieurs des doigts de test étant pourvus d'une aiguille de test (10) destinée à établir un contact électrique avec des points de contact prédéterminés de la carte de circuits imprimés (4).

10. Procédé destiné à mesurer des couches électriquement conductrices dans des trous de cartes de circuits imprimés, dans lequel un testeur à doigts selon la revendication 8 ou 9 est utilisé, l'aiguille de test avec le corps de mesure capacitif (26) est introduite dans un trou, l'emplacement du corps de mesure capacitif (26) est détecté et, simultanément, la capacité électrique du corps de mesure capacitif (26) par rapport à son environnement est mesurée, de sorte qu'il est déterminé, sur la base de la capacité mesurée, si un conducteur électrique se trouve à proximité de l'emplacement détecté.

11. Le procédé selon la revendication 10,
**caractérisé en ce que**
pour mesurer la capacité, un signal électrique ayant une fréquence d'au moins 1 kHz est appliqué à une piste conductrice, qui présente une portion électriquement conductrice dans la zone du trou à mesurer, et/ou au corps de mesure (26).

12. Le procédé selon la revendication 10 ou 11,
**caractérisé en ce que**
la détermination de la présence d'un conducteur électrique à proximité du corps de mesure (26) est effectuée par comparaison avec un profil de capacité d'un trou conforme.

13. Le procédé selon l'une quelconque des revendications 10 à 12,
**caractérisé en ce que**
au moins une piste conductrice (33) de la carte de circuits imprimés est reliée à la terre électrique, ladite piste conductrice (33) étant de préférence une piste conductrice s'étendant sur une grande partie de la carte de circuits imprimés, telle qu'une piste de masse.

14. Le procédé selon la revendication 13,
**caractérisé en ce que**
pour mesurer la capacité électrique, un appareil de mesure de courant est utilisé, dont le côté d'entrée est au potentiel de la terre électrique.

15. Le procédé selon la revendication 13 ou 14,
**caractérisé en ce qu'**
un signal de mesure est appliqué à une pluralité de couches conductrices dans la zone d'un trou métallisé, lequel signal de mesure peut être détecté par le corps de mesure (26), la pluralité de signaux de mesure étant de préférence des signaux oscillants présentant des fréquences différentes et, lors de la mesure, les différents signaux de mesure étant distingués sur la base de leurs fréquences différentes.
